Europäisches Patentamt

European Patent Office

Office européen des brevets

(11) Veröffentlichungsnummer: **0 478 811 A1**

## EUROPÄISCHE PATENTANMELDUNG

(21) Anmeldenummer: **90118798.9**

(51) Int. Cl.5: **G01R 31/26**

(22) Anmeldetag: **01.10.90**

(43) Veröffentlichungstag der Anmeldung:
**08.04.92 Patentblatt 92/15**

(84) Benannte Vertragsstaaten:
**AT BE CH DE DK ES FR GB GR IT LI LU NL SE**

(71) Anmelder: **ASEA BROWN BOVERI AG**

**CH-5401 Baden(CH)**

(72) Erfinder: **Goy, Philippe**
**Alter Kirchweg 2**
**CH-5412 Gebenstorf(CH)**

(54) **Verfahren zum Prüfen eines Leistungshalbleiter-Bauelements sowie Vorrichtung zur Durchführung des Verfahrens.**

(57) Bei einem Verfahren zur Prüfung von Leistungshalbleiter-Bauelementen (7) auf einen inneren Kurzschluss wird das Bauelement in der Schaltung belassen und im eingebauten Zustand geprüft.

Die Prüfung erfolgt über eine Messung der Streuinduktivität ($L\sigma$) zwischen den Anschlüssen (7a,b) des Bauelements. Zur Bestimmung dieser Streuinduktivität ($L\sigma$) wird vorzugsweise die Periodenlänge einer gedämpften Schwingung gemessen, die bei Entladung eines Kondensators (C) über die Streuinduktivität ($L\sigma$) entsteht.

FIG.4

EP 0 478 811 A1

## TECHNISCHES GEBIET

Die vorliegende Erfindung bezieht sich auf das Gebiet der Leistungselektronik. Sie betrifft insbesondere ein Verfahren zum Prüfen eines Leistungshalbleiter-Bauelements mit wenigstens zwei Anschlüssen auf einen inneren Kurzschluss, welches Leistungshalbleiter-Bauelement Teil einer elektrischen Schaltung ist und, wenn die elektrische Schaltung ausser Betrieb ist, innerhalb dieser elektrischen Schaltung durch eine parallele, leitende Verbindung überbrückt ist.

Die Erfindung betrifft weiterhin eine Vorrichtung zur Durchführung des Prüfverfahrens.

## STAND DER TECHNIK

In elektrischen Anlagen der Leistungselektronik (Umrichtern, Antrieben, Strom- und Spannungsversorgungen etc.) sind die zugehörigen Leistungshalbleiter-Bauelemente (Thyristoren, Dioden, Transistoren) wegen der hohen Ströme und der hohen abzuführenden Verlustleistungen in der Regel fest in die Schaltung eingebaut.

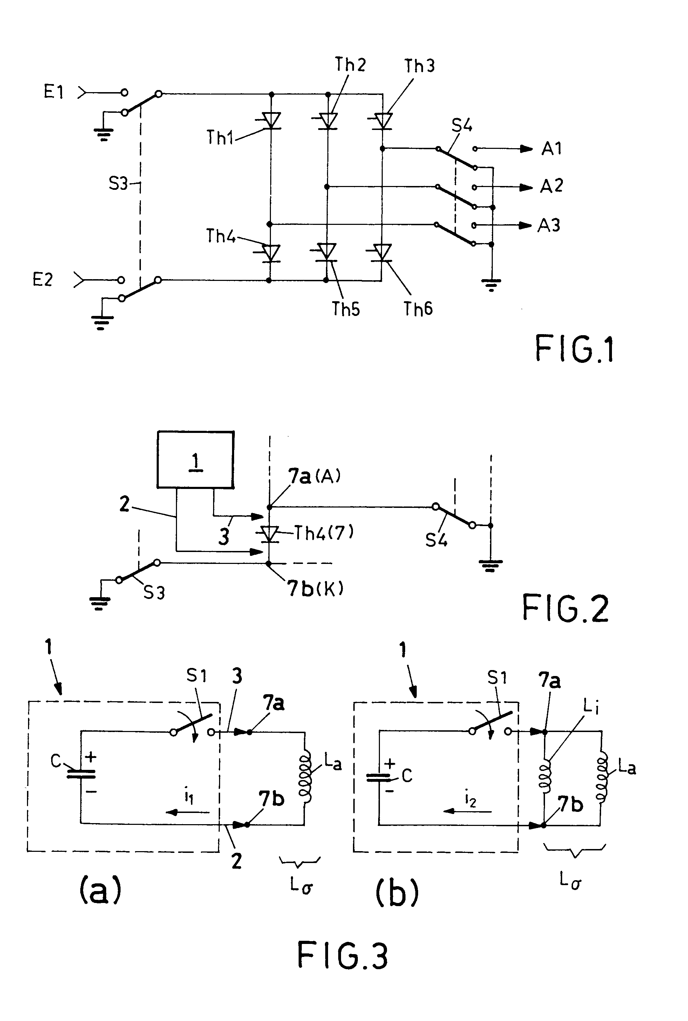

Wird nun vermutet, dass eines dieser Bauelemente defekt ist, können die in Betracht kommenden Bauelemente im eingebauten Zustand nicht in herkömmlicher Weise (Widerstandsmessung!) auf einen inneren Kurzschluss hin geprüft werden. Nach dem Abschalten der Anlage sind die Bauelemente nämlich grundsätzlich durch parallele, leitende Verbindungen innerhalb der Schaltung überbrückt (siehe Fig.1), so dass mit konventionellen Messgeräten überall Kurzschluss gemessen wird.

Bis jetzt muss daher eine solche elektrische Anlage, in der man defekte Leistungshalbleiter-Bauelemente vermutet, zerlegt werden, um die Bauelemente auszubauen und einzeln im ausgebauten Zustand zu prüfen. Diese Art der Prüfung ist jedoch einerseits aufwendig und führt andererseits zu langen Stillstandszeiten der untersuchten Anlage.

## DARSTELLUNG DER ERFINDUNG

Aufgabe der vorliegenden Erfindung ist es daher, ein Verfahren und eine Vorrichtung anzugeben, mit denen Leistungshalbleiter-Bauelemente in einer elektrischen Anlage schneller und einfacher auf inneren Kurzschluss hin überprüft werden können.

Die Aufgabe wird bei einem Verfahren der eingangs genannten Art dadurch gelöst, dass

(a) das Leistungshalbleiter-Bauelement während der Prüfung in der elektrischen Schaltung belassen wird; und

(b) zur Prüfung auf Kurzschluss die Streuinduktivität zwischen den wenigstens zwei Anschlüssen des Leistungshalbleiter-Bauelements gemessen wird.

Der Kern der Erfindung liegt darin, über eine Messung der Streuinduktivität zwischen den Anschlüssen des Bauelements zu entscheiden, ob der dort gemessene Kurzschluss hauptsächlich durch den Kurzschluss im Inneren des Bauelements oder durch die parallele, leitende Verbindung innerhalb der Schaltung bestimmt wird.

Eine bevorzugte Ausführungsform des erfindungsgemässen Verfahrens zeichnet sich dadurch aus, dass zur Messung der Induktivität zwischen den wenigstens zwei Anschlüssen

(a) an den wenigstens zwei Anschlüssen ein elektrisch geladener Kondensator über einen zunächst offenen ersten Schalter zu dem Leistungshalbleiter-Bauelement parallelgeschaltet wird;

(b) dann der erste Schalter geschlossen und der Kondensator über die zwischen den wenigstens zwei Anschlüssen bestehenden, leitenden Verbindungen entladen wird; und

(c) die Periodenlänge der entstehenden gedämpften Schwingung ausgewertet wird.

Diese Art der Messung erlaubt eine sichere Prüfung des Leistungshalbleiter-Bauelements bei gleichzeitig geringem schaltungstechnischen Aufwand.

Die erfindungsgemässe Vorrichtung zur Durchführung des Verfahrens ist dadurch gekennzeichnet, dass

(a) ein Kondensator vorgesehen ist, welcher über einen in Serie liegenden ersten Schalter mit zwei Messleitungen verbunden ist;

(b) erste Mittel zum Aufladen des Kondensators vorhanden sind; und

(c) zweite Mittel zur Bestimmung der Periodenlänge eines aus dem Kondensator und einer an die Messleitungen angeschlossenen Induktivität gebildeten Schwingkreises vorgesehen sind.

Bei einer bevorzugten Ausführungsform ist der erste Schalter ein Hilfsthyristor. Die ersten Mittel umfassen die Serieschaltung einer Gleichspannungsquelle, eines zweiten Schalters und eines Ladewiderstands, welche Serieschaltung dem Kondensator parallelgeschaltet ist. Die zweiten Mittel schliesslich umfassen eine Mess-Schaltung, welche den Hilfsthyristor ansteuert und den Spannungsabfall am Hilfsthyristor misst.

Weitere Ausführungformen der Erfindung ergeben sich aus den Unteransprüchen.

## KURZE BESCHREIBUNG DER ZEICHNUNG

Die Erfindung soll nachfolgend anhand von Ausführungsbeispielen im Zusammenhang mit der Zeichnung näher erläutert werden. Es zeigen

Fig.1 ein Beispiel für eine herkömmliche Schaltung aus der Leistungselektronik mit mehreren Leistungshalbleiter-Bauelementen im abgeschalteten Zustand;

Fig.2 die schaltungstechnische Situation beim Prüfen eines Leistungshalbleiter-Bauelements aus der Schaltung nach Fig.1 mit dem erfindungsgemässen Verfahren;

Fig.3a,b das Prinzipschaltbild für die Messung nach der Erfindung ohne (a) und mit (b) Kurzschluss im Bauelement;

Fig.4 das Prinzipschaltbild einer bevorzugten Ausführungsform der erfindungsgemässen Vorrichtung mit einer Mess-Schaltung 18;

Fig.5 das Blockschaltbild für eine bevorzugte Ausführungsform der Mess-Schaltung 18 aus Fig.4 mit einem Spannungs-Komparator 14;

Fig.6 das Schaltbild einer bevorzugten Ausführungsform des Spannungs-Komparators 14 aus Fig.5;

Fig.7 verschiedene Signalverläufe aus den Schaltungen gemäss Fig.4 und 5 bei Fehlen eines Kurzschlusses im Bauelement; und

Fig.8 verschiedene Signalverläufe aus den Schaltungen gemäss Fig.4 und 5 bei Vorhandensein eines Kurzschlusses im Bauelement.

## WEGE ZUR AUSFÜHRUNG DER ERFINDUNG

In Fig.1 ist als Beispiel aus der Leistungselektronik die schematische Schaltung eines herkömmlichen Wechselrichters wiedergegeben, bei dem eine Drehstrom-Brückenschaltung von sechs Leistungshalbleiter-Bauelementen (hier: Thyristoren Th1,..,Th6) eine an den Eingängen E1 und E2 anliegende Gleichspannung in eine dreiphasige Wechselspannung umwandelt. Diese Wechselspannung kann an den Ausgängen A1,..,A3 abgegriffen werden.

Zwischen der Thyristorbrücke und den Eingängen ebenso wie zwischen der Thyristorbrücke und den Ausgängen ist jeweils ein Schalter S3 bzw. S4 angeordnet. Bei Stillstand der Anlage sind die Schalter S3 und S4 derart geschaltet, dass alle Ein- und Ausgangsleitungen der Thyristorbrücke (wie in Fig.1 dargestellt) geerdet sind. Dies hat zur Folge, dass jeder einzelne Thyristor Th1,..,Th6 innerhalb der Schaltung über den Erdschluss kurzgeschlossen ist.

Besteht nun der Verdacht, dass einer der Thyristoren Th1,..,Th6 zerstört ist, d.h. einen inneren Kurzschluss aufweist, muss bei Anwendung der bisher üblichen Prüfmethoden (in der Regel Widerstandsmessungen) jeder einzelne der Thyristoren Th1,..,Th6 aus der Schaltung ausgebaut und im ausgebauten Zustand auf Kurzschluss geprüft werden, weil bei diesen Methoden im eingebauten Zustand nicht zwischen einem inneren Kurzschluss im Bauelement und dem schaltungstechnischen, äusseren Kurzschluss über die Erdung unterschieden werden kann.

Die vorliegende Erfindung geht hier nun einen anderen Weg (Fig.2): Das zu prüfende Leistungshalbleiter-Bauelement 7 (im Beispiel der Fig.2 ist dies der Thyristor Th4 aus der Schaltung gemäss Fig.1) wird während der Prüfung in der Schaltung belassen. Mit einem Prüfgerät 1 wird über zwei Messleitungen 2 und 3 die Streuinduktivität ($L\sigma$ in Fig.3) zwischen wenigstens zwei Anschlüssen 7a und 7b des Leistungshalbleiter-Bauelements 7 gemessen. Im Beispiel der Fig.2 sind dies die Anode A und die Kathode K des Thyristors Th4.

Der Unterschied der erfindungsgemässen Induktivitätsmessung zur herkömmlichen Widerstandsmessung im eingebauten Zustand ist der folgende:

Die Leitungslänge für den inneren Kurzschluss im Bauelement ist zunächst einmal, wie aus Fig.2 leicht zu erkennen ist, in der Regel wesentlich kleiner als die Leitungslänge für den schaltungstechnisch bedingten, äusseren Kurzschluss. Gelingt es daher, diesen Unterschied messtechnisch auszuwerten, lässt sich entscheiden, ob das untersuchte Bauelement einen internen Kurzschluss aufweist (d.h. über den kurzen Leitungsweg kurzgeschlossen ist) oder nicht.

Bei einer Widerstandsmessung kann dieser Unterschied in den Leitungslängen nicht eindeutig ausgewertet werden. Er kann nämlich dadurch aufgehoben oder ins Gegenteil verkehrt werden, dass der äussere Kurzschluss über Leitungen mit sehr grossem Querschnitt und kleinem spezifischen Widerstand erfolgt. Trotz unterschiedlicher Leitungslängen können sich dann Gesamtwiderstände für beide Kurzschlusspfade ergeben, die eine Entscheidung über die Funktionstüchtigkeit des Bauelements unmöglich machen.

Bei der erfindungsgemässen Induktivitätsmessung ist die Situation anders: Die deutlich unterschiedliche Leitungslänge drückt sich direkt auch in einer deutlich unterschiedlichen Streuinduktivität aus, so dass bei einer ausreichend genauen Bestimmung dieser Streuinduktivität eine eindeutige Aussage darüber getroffen werden kann, ob das untersuchte Bauelement einen inneren Kurzschluss aufweist oder nicht.

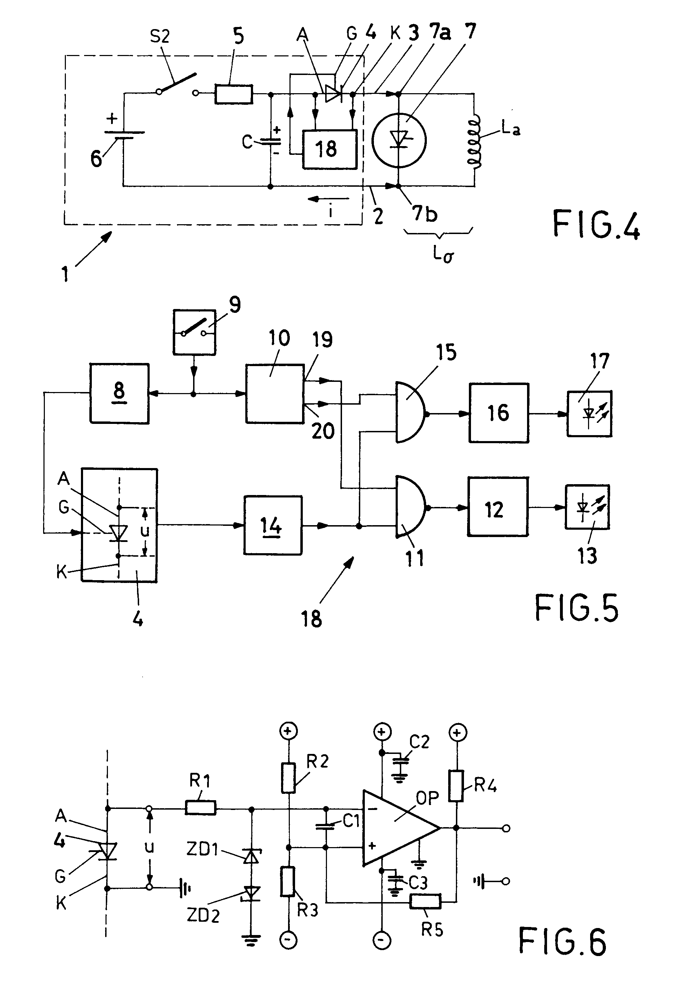

Gemäss einem bevorzugten Ausführungsbeispiel des erfindungsgemässen Verfahrens (Fig.3a,b; Fig.4) wird zur Messung der Streuinduktivität $L\sigma$ zwischen den wenigstens zwei Anschlüssen 7a und 7b des Leistungshalbleiter-Bauelements 7

(a) an den wenigstens zwei Anschlüssen 7a und 7b ein elektrisch geladener Kondensator C über einen zunächst offenen ersten Schalter S1 zu dem Leistungshalbleiter-Bauelement 7 parallelgeschaltet;

(b) dann der erste Schalter S1 geschlossen und der Kondensator C über die zwischen den wenigstens zwei Anschlüssen 7a und 7b bestehenden, leitenden Verbindungen entladen; und

(c) die Periodenlänge der entstehenden gedämpften Schwingung ausgewertet.

Die prinzipielle Messanordnung für dies bevorzugte Ausführungsbeispiel ist in der Fig.3 für den Fall eines fehlerlosen Bauelements (Fig.3a) und für den Fall eines Bauelements mit innerem Kurzschluss (Fig.3b) dargestellt.

In beiden Fällen bildet das Prüfgerät 1 mit dem (geladenen) internen Kondensator C über den ersten Schalter S1 und die Messleitungen 2 und 3 zusammen mit der Streuinduktivität $L_\sigma$ zwischen den Anschlüssen 7a und 7b einen Schwingkreis. Wird der erste Schalter S1 bei geladenem Kondensator C geschlossen, fliesst ein Strom $i_1$ bzw. $i_2$ über die Streuinduktivität $L_\sigma$. Es entsteht eine Schwingung, deren Periodenlänge in bekannter Weise von der Kapazität des Kondensators C und der Streuinduktivität $L_\sigma$ abhängt. Die Schwingung ist im übrigen wegen der (in Fig.3 nicht eingezeichneten) unvermeidlichen Leitungswiderstände gedämpft.

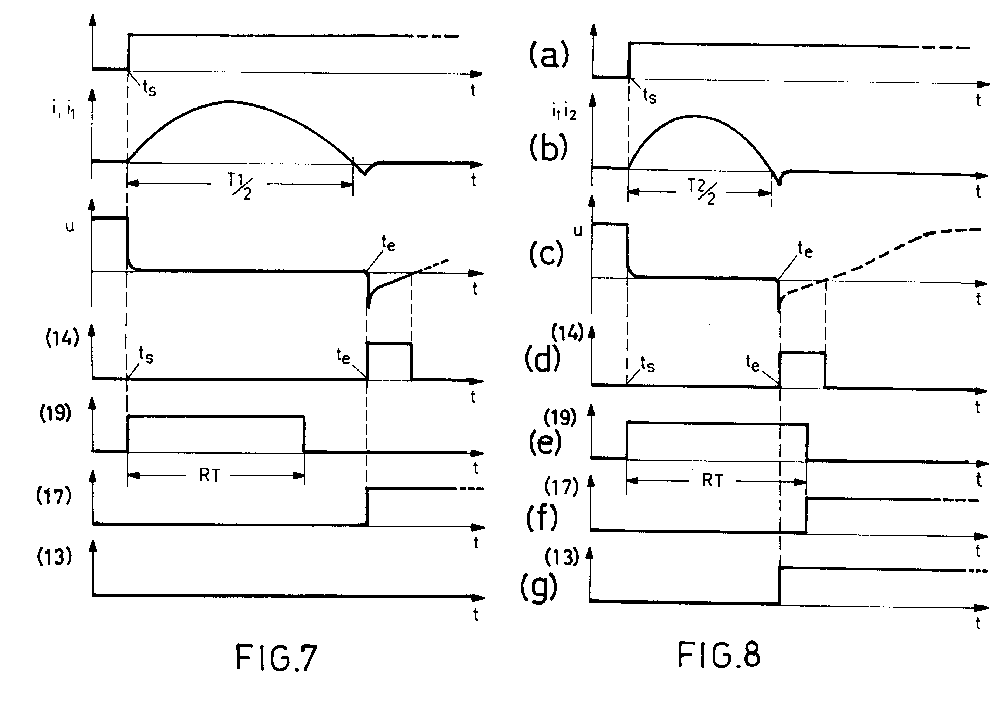

Im ersten Fall (fehlerfreies Bauelement; Fig.3a) ist, weil das Bauelement sperrt, die frequenzbestimmende Streuinduktivität $L_\sigma$ im wesentlichen gleich der äusseren Induktivität $L_a$ des schaltungstechnischen Kurzschlusses. Da $L_a$ vergleichsweise grösser ist, ergibt sich für die gedämpfte Schwingung eine grössere Periodenlänge (T1 in Fig.7b).

Im zweiten Fall (Bauelement mit innerem Kurzschluss; Fig.3b) resultiert die frequenzbestimmende Streuinduktivität $L_\sigma$ aus einer Parallelschaltung der äusseren Induktivität $L_a$ und einer inneren Induktivität $L_i$ des im Bauelement verlaufenden Kurzschlusspfades. Da die innere Induktivität $L_i$ deutlich kleiner ist als die äussere Induktivität, ergibt sich für die gedämpfte Schwingung eine deutlich kleinere Periodenlänge (T2 in Fig.8b).

Daraus folgt, dass aus einer Auswertung der Periodenlänge der gedämpften Schwingung prinzipiell auf den Zustand des eingebauten Leistungshalbleiter-Bauelements 7 geschlossen werden kann. Besonders einfach ist es dabei, anstelle der gesamten Periodenlänge die Länge einer Halbperiode zu bestimmen.

Wird nun eine Zeitspanne vorgegeben, die zwischen den beiden Halbperiodenlängen T1/2 und T2/2 liegt, kann durch Vergleich der gemessenen Halbperiodenlänge mit dieser Zeitspanne (der Referenzzeit RT in Fig.7e,8e) in einer einfachen (Ja/Nein)-Entscheidung festgestellt werden, ob das untersuchte Bauelement einen internen Kurzschluss aufweist oder nicht.

Ein Ausführungsbeispiel für das Prüfgerät 1, mit dem die Periodenlänge bestimmt werden kann, ist in der Fig. 4 dargestellt. Kernstück des Prüfgeräts 1 ist wiederum der Kondensator C. Der erste Schalter S1 aus Fig.3 wird hier durch einen Hilfthyristor 4 gebildet. Der Kondensator C kann aus einer Gleichspannungsquelle 6 über einen zweiten Schalter S2 und einen Ladewiderstand 5 bei Bedarf geladen werden.

Die gedämpfte Schwingung wird dadurch eingeleitet, dass der Hilfsthyristor 4 über sein Gate G gezündet wird. Der Kondensator C lädt sich dann in einer ersten Halbperiode mit einem Strom i bzw. $i_1$ oder $i_2$ über die äussere Induktivität $L_a$ und - im Falle eines Fehlers - auch über das zu prüfende Leistungshalbleiter-Bauelement 7 um. Nach dem Nulldurchgang des Stromes i am Ende der ersten Halbperiode sperrt der Hilfsthyristor 4 wieder (Fig.7b,8b).

Die am Hilfsthyristor 4 zwischen Anode A und Kathode K abfallende Spannung zeigt in dieser Phase folgendes Verhalten (Fig.7c,8c): Bevor der Hilfsthyristor 4 gezündet wird, ist diese Spannung gleich der Ladespannung des Kondensators C. Sobald der Hilfsthyristor gezündet ist, fällt die Spannung auf Werte nahe 0 ab (Durchlass-Spannung) und wechselt schliesslich das Vorzeichen, wenn der Kondensator C am Ende der Halbperiode umgeladen ist und der Hilfsthyristor 4 sperrt und wieder Sperrspannung aufnimmt. Die am Hilfsthyristor 4 abfallende Spannung wird nun zur Bestimmung der Halbperiodenlänge herangezogen.

Zur Bereitstellung des Zündimpulses für den Hilfsthyristor 4 und zur Messung der am Hilfsthyristor 4 abfallenden Spannung ist in dem Prüfgerät 1 nach Fig.4 eine Mess-Schaltung 18 vorgesehen, deren innerer Aufbau in einem bevorzugten Ausführungsbeispiel in Fig.5 wiedergegeben ist.

Die Mess-Schaltung 18 umfasst in dieser Ausführungsform einen Startimpulsgeber 9, einen Zündstromgenerator 8 für den Hilfsthyristor 4, eine Referenzzeitbasis 10, einen Spannungs-Komparator 14, zwei NAND-Gatter 11 und 15, zwei Monoflops 12 und 16 sowie zwei Anzeigeeinheiten 13 und 17.

Der Startimpulsgeber 9 triggert gleichzeitig den Zündstromgenerator 8 und die Referenzzeitbasis 10. Die am Hilfsthyristor 4 abfallende Spannung wird im Spannungs-Komparator 14 mit einer vorgegebenen Spannung verglichen, um den Vorzeichenwechsel am Ende der Halbperiode festzustellen.

Die Referenzzeitbasis 10 ist ein Monoflop mit einem nicht-invertierenden (19) und einem invertierenden (20) Ausgang. Der nicht-invertierende Ausgang 19 der Referenzzeitbasis 10 und der Ausgang des Spannungs-Komparators 14 sind jeweils mit einem Eingang des ersten NAND-Gatters 11 verbunden. Der Ausgang des ersten NAND-Gatters steht mit der ersten Anzeigeeinheit 13 über das erste Monoflop 12 in Wirkverbindung.

Der invertierende Ausgang 20 der Referenzzeitbasis 10 und der Ausgang des Spannungs-Komparators 14 sind jeweils mit einem Eingang des zweiten NAND-Gatters 16 verbunden, dessen Ausgang über den zweiten Monoflop 16 mit der zweiten Anzeigeeinheit 17 in Wirkverbindung steht. Die erste Anzeigeeinheit 13 zeigt an, ob das untersuchte Leistungshalbleiter-Bauelement fehlerhaft ist oder nicht. Die zweite Anzeigeeinheit 17 zeigt das Ende eines Bauelement-Tests an.

Die einzelnen Vorgänge in der Schaltung gemäss Fig.4 und 5 sollen anhand der in den Fig.7 und 8 dargestellten Signalverläufe (Signale über der Zeit t) nachfolgend näher erläutert werden. Fig.7 zeigt dabei verschiedene Signalverläufe (a)-(g) für den Fall eines fehlerfreien Bauelements. Fig.8 zeigt die entsprechenden Signalverläufe für den Fall eines Bauelements mit innerem Kurzschluss.

Die Prüfung des Bauelements beginnt zu einer Startzeit $t_s$ durch einen Startimpuls aus dem Startimpulsgeber 9 (Fig.7a,8a). Der Startimpuls zündet über den Zündimpulsgeber 8 gleichzeitig den Hilfsthyristor 4 und startet den Monoflop der Referenzzeitbasis 10. Sobald der Hilfsthyristor 4 leitet, lädt sich der Kondensator C mit einem sinusförmigen Strom i bzw. $i_1$ oder $i_2$ um (Fig.7b,8b). Die Leitphase hat dabei die Länge einer halben Periode (T1/2 bzw. T2/2) zwischen der Startzeit $t_s$ und dem Nulldurchgang des Stromes i. Nach dem Nulldurchgang fliesst ein negativer Strom (Rückstromspitze), der vom Ausräumen der Ladungsträger im Hilfsthyristor 4 herrührt.

Die am Hilfsthyristor 4 abfallende Spannung u hat während der Halbperiode (und danach) den in Fig.7c und 8c dargestellten Verlauf. Sie fällt direkt nach der Startzeit $t_s$ von der Ladespannung des Kondensators C auf die nahe 0 liegende Durchlass-Spannung und bleibt für den Rest der Halbperiode auf diesem Wert, bis zu einer Endzeit $t_e$ derHilfsthyristor 4 von Ladungsträgern freigeräumt ist und wieder Sperrspannung aufnimmt. Die Spannung u wechselt dann ihr Vorzeichen (weil der Kondensator C umgeladen ist) und kehrt anschliessend langsam auf den ursprünglichen positiven Wert zurück (gestrichelte Linie in Fig.7c,8c), wenn der zweite Schalter S2 noch geschlossen ist, und der Kondensator über die Gleichspannungsquelle 6 erneut umgeladen wird.

Der Vorzeichenwechsel der Spannung u wird mittels des Spannungs-Komparators 14 detektiert, der für die entsprechende Zeitspanne, in welcher u < 0 gilt, einen positiven Impuls am Ausgang abgibt (Fig.7d,8d). Durch die Zeitpunkte $t_s$ und $t_e$ wird eine Zeitspanne festgelegt, die im wesentlichen (bis auf die Freiwerdezeit des Hilfsthyristors 4) gleich der Halbperiodenlänge (T1/2 bzw. T2/2) der gedämpften Schwingung ist.

Diese Zeitspanne wird nun mit einer intern in der Referenzzeitbasis 10 erzeugten, vorgegebenen Referenzzeit RT (Fig.7e,8e) verglichen. Diese Referenzzeit RT ist so gewählt, dass sie

(a) kleiner ist als die halbe Periodenlänge (T1/2) der gedämpften Schwingung für den Fall, in welchem das Leistungshalbleiter-Bauelement 7 fehlerlos ist und normal sperrt; und

(b) grösser ist als die halbe Periodenlänge (T2/2) der gedämpften Schwingung für den Fall, in welchem das Leistungshalbleiter-Bauelement 7 kurzschlussbehaftet ist.

Ist nun das Bauelement fehlerfrei (Fig.7), ist die Zeitspanne $t_e$-$t_s$ länger als die Referenzzeit RT. Die Impulse aus dem Spannungs-Komparator 14 und der Referenzzeitbasis 10 überlappen zeitlich nicht. Der Ausgang des ersten NAND-Gatters 12 bleibt daher unverändert, so dass der erste Monoflop 12 nicht getriggert wird und die erste Anzeigeeinheit 13 dunkel bleibt (Fig.7g).

Ist das Bauelement dagegen kurzschlussbehaftet (Fig.8), ist die Zeitspanne $t_e$-$t_s$ kürzer als die Referenzzeit RT. Die Impulse aus dem Spannungs-Komparator 14 und der Referenzzeitbasis 10 überlappen zeitlich. Am Ausgang des ersten NAND-Gatters 12 erscheint dann eine negative Flanke, durch die der erste Monoflop 12 am negativen Triggereingang getriggert wird und während seiner Laufzeit die erste Anzeigeeinheit 13 durchsteuert.

In beiden Fällen wird das Ende der Messung durch die zweite Anzeigeeinheit 17 angezeigt (Fig.7f,8f), wenn der invertierende Ausgang 20 der Referenzzeitbasis 10 nach Ablauf der Referenzzeit RT auf logisch "1" zurückspringt, mit dem Impuls aus dem Spannungs-Komparator 14 überlappt, und über das zweite NAND-Gatter 15 den zweiten Monoflop 16 durch seinen negativen Triggereingang zum Umkippen bringt.

Ein beispielhafter Aufbau des Spannungs-Komparators 14 ist schliesslich in der Fig.6 dargestellt. Er umfasst einen Operationsverstärker OP. Die am Hilfsthyristor 4 abfallende Spannung u wird über einen ersten Widerstand R1 auf den negativen Eingang des Operationsverstärkers OP gegeben. Parallel zum negativen Eingang sind zwei Zenerdioden in Serie angeordnet. Die Vergleichsspannung wird von einem Spannungsteiler mit den Widerständen R2 und R3 abgenommen und auf den positiven Eingang des Operationsverstärkers OP gegeben. Der Ausgang des Operationsverstärkers OP ist einerseit über den Widerstand R5 auf den positiven Eingang zurückgekoppelt und andererseits über den Widerstand R4 an die positive Versorgungsspannung angeschlossen. Kondensatoren C1, C2 und C3 dienen der Stabilisierung der Schaltung.

In einer praktisch erprobten Ausführungsform des Prüfgerätes 1 wurden folgende Bauelemente und Daten verwendet:

Kondensator C:

42 $\mu$F

Ladespannung:

45 V

Referenzzeit RT:

26,5 ±1 $\mu$s

Operationsverstärker OP:

LM 311

Hilfsthyristor 4:

BBC CS 16-04

Referenzzeitbasis 14:

1/2 4538

Monoflops 12,16:

1/2 4538

Mit einem solchen Prüfgerät ergab sich bei einer Ueberprüfung von Thyristoren in einem Stromrichter vom Typ Verithyr PSRM 1DB1-3 der Firma BBC z.B. eine Halbperiodenlänge von T1/2 $\geqq$ 30 $\mu$s für intakte Thyristoren und T2/2 $\approx$ 17 $\mu$s für defekte Thyristoren.

Zum Schluss sei noch darauf hingewiesen, dass mit dem Verfahren und dem Prüfgerät der Erfindung nicht nur beidseitig sperrende Bauelemente überprüft werden können, sonder auch Dioden und Rückwärtsleitende Thyristoren. In diesen Fällen muss die Ueberprüfung in beiden Richtungen (positive und negative Polung) durchgeführt werden.

**Patentansprüche**

1. Verfahren zum Prüfen eines Leistungshalbleiter-Bauelements (7) mit wenigstens zwei Anschlüssen (7a,b) auf einen inneren Kurzschluss, welches Leistungshalbleiter-Bauelement (7) Teil einer elektrischen Schaltung ist und, wenn die elektrische Schaltung ausser Betrieb ist, innerhalb dieser elektrischen Schaltung durch eine parallele, leitende Verbindung überbrückt ist, dadurch gekennzeichnet, dass

   (a) das Leistungshalbleiter-Bauelement (7) während der Prüfung in der elektrischen Schaltung belassen wird; und

   (b) zur Prüfung auf Kurzschluss die Streuinduktivität (L$\sigma$) zwischen den wenigstens zwei Anschlüssen (7a,b) des Leistungshalbleiter-Bauelements (7) gemessen wird.

2. Verfahren nach Anspruch 1, dadurch gekennzeichnet, dass zur Messung der Streuinduktivität (L$\sigma$) zwischen den wenigstens zwei Anschlüssen (7a,b)

   (a) an den wenigstens zwei Anschlüssen (7a,b) ein elektrisch geladener Kondensator (C) über einen zunächst offenen ersten Schalter (S1) zu dem Leistungshalbleiter-Bauelement (7) parallelgeschaltet wird;

   (b) dann der erste Schalter (S1) geschlossen und der Kondensator (C) über die zwischen den wenigstens zwei Anschlüssen (7a,b) bestehenden, leitenden Verbindungen entladen wird; und

   (c) die Periodenlänge der entstehenden gedämpften Schwingung ausgewertet wird.

3. Verfahren nach Anspruch 2, dadurch gekennzeichnet, dass

   (a) das Leistungshalbleiter-Bauelement (7) im Kurzschlussfall zwischen den wenigstens zwei Anschlüssen (7a,b) eine innere Induktivität (L$_i$) aufweist;

   (b) die parallele, leitende Verbindung zwischen den wenigstens zwei Anschlüssen (7a,b) eine äussere Induktivität (L$_a$) aufweist, welche grösser ist als die innere Induktivität (L$_i$); und

   (c) die Länge einer Halbperiode der entstehenden gedämpften Schwingung mit einer vorgegebenen Referenzzeit (RT) verglichen wird, wobei die vorgegebene Referenzzeit (RT) so gewählt wird, dass sie

      (aa) kleiner ist als die halbe Periodenlänge (T1/2) der gedämpften Schwingung für den Fall, in welchem das Leistungshalbleiter-Bauelement (7) fehlerlos ist und normal sperrt; und

      (bb) grösser ist als die halbe Periodenlänge (T2/2) der gedämpften Schwingung für den Fall, in welchem das Leistungshalbleiter-Bauelement (7) kurzschlussbehaftet ist.

4. Verfahren nach Anspruch 3, dadurch gekennzeichnet, dass

   (a) als erster Schalter (S1) ein Hilfsthyristor (4) verwendet wird; und

   (b) zur Bestimmung der halben Periodenlänge (T1/2;T2/2) die am Hilfsthyristor (4) abfallende Spannung (u) gemessen und der Zeitpunkt bestimmt wird, in welchem der Hilfsthyristor (4) nach der ersten Halbperiode wieder Sperrspannung aufnimmt.

5. Vorrichtung zur Durchführung des Verfahrens nach Anspruch 1, dadurch gekennzeichnet, dass

(a) ein Kondensator (C) vorgesehen ist, welcher über einen in Serie liegenden ersten Schalter (S1) mit zwei Messleitungen (2,3) verbunden ist;

(b) erste Mittel zum Aufladen des Kondensators (C) vorhanden sind; und

(c) zweite Mittel zur Bestimmung der Periodenlänge eines aus dem Kondensator (C) und einer an die Messleitungen (2,3) angeschlossenen Induktivität gebildeten Schwingkreises vorgesehen sind.

6. Vorrichtung nach Anspruch 5, dadurch gekennzeichnet, dass (a) der erste Schalter (S1) ein Hilfsthyristor (4) ist;

(b) die ersten Mittel die Serieschaltung einer Gleichspannungsquelle (6), eines zweiten Schalters (S2) und eines Ladewiderstands (5) umfassen, welche Serieschaltung dem Kondensator (C) parallelgeschaltet ist; und

(c) die zweiten Mittel eine Mess-Schaltung (18) umfassen, welche den Hilfsthyristor (4) ansteuert und den Spannungsabfall am Hilfsthyristor (4) misst.

7. Vorrichtung nach Anspruch 6, dadurch gekennzeichnet, dass

(a) die Mess-Schaltung (18) einen Zündstromgenerator (8) mit einem Triggereingang und einem Ausgang, einen Startimpulsgeber (9) mit einem Ausgang, eine Referenzzeitbasis (10) mit einem Triggereingang und einem nicht-invertierenden Ausgang (19), einen Spannungskomparator (14) mit einem Eingang und einem Ausgang, ein erstes NAND-Gatter (11) mit zwei Eingängen und einem Ausgang, und eine erste Anzeigeeinheit (13) umfasst;

(b) der Ausgang des Startimpulsgebers (9) mit den Triggereingängen des Zündstromgenerators (8) und der Referenzzeitbasis (10) verbunden ist;

(c) der Ausgang des Zündstromgenerators (8) mit dem Gate (G), und der Eingang des Spannungs-Komparators (14) mit Anode (A) und Kathode (K) des Hilfsthyristors (4) verbunden sind;

(d) der nicht-invertierende Ausgang (19) der Referenzzeitbasis (10) und der Ausgang des Spannungs-Komparators (14) mit den Eingängen des ersten NAND-Gatters (11) verbunden sind; und

(e) die erste Anzeigeeinheit (13) vom Ausgang des ersten NAND-Gatters (11) gesteuert wird.

8. Vorrichtung nach Anspruch 7, dadurch gekennzeichnet, dass

(a) der Spannungs-Komparator (14) einen Operationsverstärker (OP) mit einem positiven und negativen Eingang umfasst;

(b) die am Hilfsthyristor (4) abfallende Spannung (u) auf den negativen Eingang des Operationsverstärkers (OP) gegeben wird, während eine Vergleichsspannung am positiven Eingang anliegt; und

(c) die Referenzzeitbasis (10) als Monoflop ausgebildet ist.

9. Vorrichtung nach Anspruch 8, dadurch gekennzeichnet, dass

(a) die Referenzzeitbasis (10) einen invertierenden Ausgang (20) aufweist;

(b) ein zweites NAND-Gatter (15) mit zwei Eingängen und einem Ausgang sowie eine zweite Anzeigeeinheit (17) vorhanden sind;

(c) der invertierende Ausgang (20) der Referenzzeitbasis (10) und der Ausgang des Spannungs-Komparators (14) mit den Eingängen des zweiten NAND-Gatters (15) verbunden sind; und

(d) die zweite Anzeigeeinheit (17) vom Ausgang des zweiten NAND-Gatters (15) gesteuert wird.

10. Vorrichtung nach Anspruch 9, dadurch gekennzeichnet, dass zwischen der ersten Anzeigeeinheit (13) und dem ersten NAND-Gatter (11) und der zweiten Anzeigeeinheit (17) und dem zweiten NAND-Gatter (15) jeweils ein Monoflop (12 bzw. 16) angeordnet ist.

FIG.1

FIG.2

(a)          (b)

FIG.3

FIG.4

FIG.5

FIG.6

FIG.7

FIG.8

EP 0 478 811 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-4 659 983 (P.O. JACOB)<br>* das ganze Dokument * | 1,2 | G 01 R 31/26 |
| A | | 5 | |
| A | DE-A-2 552 577 (ALLMÄNNA SVENSKA ELEKTRISKA AB)<br>* Seite 3, Zeile 2 - Seite 6, Zeile 1; Figuren 1-3 * | 1 | |

**RECHERCHIERTE SACHGEBIETE (Int. Cl.5)**

G 01 R 31/26

**Der vorliegende Recherchenbericht wurde für alle Patentansprüche erstellt**

| Recherchenort | Abschlußdatum der Recherche | Prüfer |
|---|---|---|
| Berlin | 04 Juni 91 | LEMMERICH J |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder
    nach dem Anmeldedatum veröffentlicht worden ist
D : in der Anmeldung angeführtes Dokument
L : aus anderen Gründen angeführtes Dokument
--------------------------------------------------------------------------
& : Mitglied der gleichen Patentfamilie,
    übereinstimmendes Dokument